# EUROPÄISCHE PATENTSCHRIFT

(11) **EP 3 055 741 B1**
(45) Veröffentlichungstag und Bekanntmachung des Hinweises auf die Patenterteilung: **04.12.2019**
(21) Anmeldenummer: 14781528.6
(22) Anmeldetag: 07.10.2014
(51) Int. Cl.: G05B 19/042, H05K 7/14, G06F 13/20, G06F 13/40

(54) **MODULARE STEUERVORRICHTUNG MIT LASTÜBERWACHUNG**
MODULAR CONTROL APPARATUS WITH LOAD MONITORING
DISPOSITIF DE COMMANDE MODULAIRE AVEC SURVEILLANCE DE CHARGE

(30) Priorität: 09.10.2013 DE 102013111179
(43) Veröffentlichungstag der Anmeldung: 17.08.2016
(73) Patentinhaber: Pilz GmbH & Co. KG, 73760 Ostfildern (DE)
(72) Erfinder: VEIL, Richard, 73760 Ostfildern (DE); HARRER, Bernd, 73760 Ostfildern (DE)
(74) Vertreter: Witte, Weller & Partner Patentanwälte mbB
(86) Internationale Anmeldenummer: PCT/EP2014/071422
(87) Internationale Veröffentlichungsnummer: WO 2015/052174

(56) Entgegenhaltungen:
- EP-A2- 1 771 054
- EP-A2- 2 620 820
- DE-A1-102011 110 184

## Beschreibung

Die vorliegende Erfindung betrifft eine modulare Steuervorrichtung, insbesondere eine Sicherheitsschaltvorrichtung. Die modulare Steuervorrichtung weist ein Kopfmodul, mindestens ein Einspeisemodul und mindestens ein Peripheriemodul auf, die nebeneinander am Kopfmodul angeordnet sind, sowie mindestens eine Busstruktur, wobei das mindestens eine Einspeisemodul und das mindestens eine Peripheriemodul einen Basismodulteil, einen Elektronikmodulteil und einen Anschlussmodulteile aufweisen.

Die Erfindung betrifft ferner ein Einspeisemodul für eine solche Steuervorrichtung.

Eine modulare Steuervorrichtung dieser Art ist beispielsweise aus der EP 1 771 054 A2 bekannt.

Ebenso sind eine Steuervorrichtung und ein Einspeisemodul dieser Art aus der Beschreibung, PSS Universal, Programmierbare Steuersysteme PSS, Systembeschreibung, Nr. 21256-DE-04 der Anmelderin bekannt.

Eine Steuervorrichtung im Sinne der vorliegenden Erfindung kann beispielsweise eine modulare Steuervorrichtung für eine konfigurierbare oder programmierbare Steuerung sein. Eine Steuervorrichtung setzt sich modular aus einer zentralen Kopfeinheit und nebeneinander angeordneten Modulen zusammen. Die Module sind untereinander und mit dem Kopfmodul über einen separaten Bus verbunden. Die Module sind überwiegend Eingangs- und Ausgangsmodule, über die sich die zu steuernde Peripherie anschließen lässt. Die Ein- und Ausgangsmodule werden daher oft auch als Peripheriemodule bezeichnet. Eingangsmodule nehmen Signale der externen Peripherie, beispielsweise Meldegeräte wie Türkontaktschalter, Lichtschranken oder Not-Aus-Taster, auf. Über die Ausgangsmodule werden angeschlossene Aktoren, beispielsweise Schütze, Magnetventile, Lampen, gesteuert und ggf. mit Strom versorgt. Der dazu benötigte Strom wird den Ausgangsmodulen über die Einspeisemodule bereitgestellt.

Die Einspeisemodule werden wie Eingangs- und Ausgangsmodule an der Steuervorrichtung angeordnet und mit dem gemeinsamen Bus verbunden. Über externe Anschlüsse an den Einspeisemodulen kann ein Peripheriestrom in die Steuervorrichtung eingespeist werden und über den Bus an die entsprechenden Ausgangsmodule weitergeleitet werden. Der Peripheriestrom wird von externen Netzteilen bereitgestellt, die beispielsweise eine Netzspannung von 230 Volt AC in eine entsprechende Betriebsspannung von 24 Volt DC umwandeln. Die Netzteile sind für die Bereitstellung von verschiedenen Stromstärken ausgelegt und verfügen über Sicherungsmechanismen, beispielsweise in Form von Schmelzsicherungen, die bei Überschreiten eines gewissen Schwellwerts auslösen und den Strompfad zur Steuereinheit unterbrechen.

Üblicherweise werden mehrere Ausgangsmodule von einem einzelnen Einspeisemodul versorgt, wie es auch in der eingangs genannten Systembeschreibung der PSS Universal Nr. 21256-DE-04 beschrieben ist. Ferner werden innerhalb einer Steuervorrichtung verschiedene Potenzialgruppen gebildet, die sich jeweils aus einem Einspeisemodul und zugehörigen Ausgabemodulen zusammensetzen. Die Module einer Potenzialgruppe werden zusammenhängend an dem Bus angeordnet, wobei jede Potenzialgruppe mit einem Einspeisemodul beginnt. Je mehr Ausgangsmodule einem einzelnen Einspeisemodul zugeordnet sind, desto höher ist üblicherweise der Strom, den ein Einspeisemodul von extern aufnimmt.

Insbesondere bei Leistungsspitzen, beispielsweise beim Ein- bzw. Ausschalten, kann die Last für ein Einspeisemodul zu hoch werden, so dass entweder eine interne Sicherung oder eine externe Sicherung des externen Netzteils auslöst und die Steuerungsvorrichtung und/oder einzelne Potenzialgruppen stromlos schaltet. Auf diese Weise kann grundsätzlich vermieden werden, dass die Steuervorrichtung oder einzelne Module beschädigt werden. Ein derartiges unkontrolliertes Abschalten ist jedoch unerwünscht und beeinträchtigt die Verfügbarkeit des Gesamtsystems.

Es ist daher eine Aufgabe der vorliegenden Erfindung, eine Steuervorrichtung anzugeben, die besser und sicherer auf eine Überlast reagiert.

Diese Aufgabe wird gelöst durch eine modulare Steuervorrichtung eingangsgenannter Art, gekennzeichnet dadurch, dass das mindestens eine Einspeisemodul dazu ausgebildet ist, das mindestens eine Peripheriemodul mit einem externen Peripheriestrom zu versorgenm, wobei das Anschlussmodulteil des mindestens einen Einspeisemoduls einen Einspeiseanschluss zum Einspeisen des externen Peripheriestroms aufweist, wobei das Anschlussmodulteil des mindestens einen Peripheriemoduls einen Ausgang zum Anschließen eines Aktors bereitstellt zum Ausgeben des in das Einspeisemodul eingespeisten Peripheriestroms, wobei die nebeneinander angeordneten Basismodulteile die Busstruktur bereitstellen, über die das Kopfmodul, das mindestens eine Einspeisemodul und das mindestens eine Peripheriemodul miteinander elektrisch gekoppelt sind, so dass der externe Peripheriestrom über die Busstruktur von einem Modul zum danebenliegenden Modul übertragen werden kann, wobei das Einspeisemodul ferner aufweist: eine elektrische Leitung mit einem definierten Querschnitt, die vom Anschlussmodulteil durch das Elektronikmodulteil hin zum Busmodulteil verläuft und mindestens einen Einspeiseanschluss des Einspeisemoduls mit der Busstruktur verbindet und eine Überlasterkennungseinheit, die an der elektrischen Leitung angeordnet ist und einen Parameter der elektrischen Leitung bestimmt und eine Warnmeldung erzeugt, wenn der Parameter einen Grenzwert überschreitet.

Gemäß einem weiteren Aspekt der vorliegenden Erfindung wird die Aufgabe durch ein Einspeisemodul für eine modulare Steuervorrichtung gelöst, die ein Kopfmodul und mindestens ein Peripheriemodul aufweist, die über eine Busstruktur miteinander gekoppelt sind, wobei das Einspeisemodul einen Basismodulteil, einen Elektronikmodulteil und einen Anschlussmodulteil mit mindestens einem Einspeiseanschluss aufweist, gekennzeichnet dadurch, dass das mindestens eine Einspeisemodul dazu ausgebildet ist, mindestens ein Peripheriemodul mit einem externen Peripheriestrom zu versorgen, wobei das Einspeisemodul eine elektrische Leitung mit einem definierten Querschnitt aufweist, die vom Anschlussmodulteil durch das Elektronikmodulteil hin zum Busmodulteil verläuft, so dass der mindestens eine Einspeiseanschluss des Einspeisemoduls mit der Busstruktur verbindbar ist, und wobei das Einspeisemodul eine Überlasterkennungseinheit aufweist, die an der elektrischen Leitung angeordnet ist und einen Parameter der elektrischen Leitung bestimmt und eine Warnmeldung erzeugt, wenn der Parameter einen Grenzwert überschreitet.

Gemäß einem weiteren Aspekt der vorliegenden Erfindung wird die Aufgabe durch ein Verfahren zum Einspeisen eines Peripheriestroms in eine modulare Steuervorrichtung gelöst, mit den Schritten:
B ereitstellen einer modularen Steuervorrichtung mit einem Kopfmodul, mindestens einem Einspeisemodul und mindestens einem Peripheriemodul, die nebeneinander am Kopfmodul angeordnet sind, wobei das mindestens eine Einspeisemodul und das mindestens eine Peripheriemodul mindestens einen Basismodulteil, einen Elektronikmodulteil und einen Anschlussmodulteil aufweisen,
gekennzeichnet durch
- Aufnehmen eines externen Peripheriestroms über einen Einspeiseanschluss am Anschlussmodulteil des mindestens einen Einspeisemoduls,
- Bereitstellen einer Busstruktur aus den nebeneinander angeordneten Basismodulteilen, über die das Kopfmodul, das mindestens eine Einspeisemodul und das mindestens eine Peripheriemodul miteinander elektrisch gekoppelt sind, so dass der Peripheriestrom über die Busstruktur von einem Modul zum danebenliegenden Modul übertragen werden kann,
- Versorgen des mindestens eine Peripheriemodul mit dem Peripheriestrom durch das mindestens eine Einspeisemodul,
- Bereitstellen einer elektrischen Leitung in dem mindestens einen Einspeisemodul mit einer Überlasterkennungseinheit, wobei die elektrische Leitung einen definierten Querschnitt aufweist und vom Anschlussmodulteil durch das Elektronikmodulteil hin zum Busmodulteil hin verläuft und den mindestens einen Einspeiseanschluss des Einspeisemoduls mit der Busstruktur verbindet,
- Ausgeben des Peripheriestroms über einen Ausgang am Anschlussmodulteil des mindestens einen Peripheriemoduls,
- Bestimmen eines Parameters der elektrischen Leitung durch die Überlasterkennungseinheit,
- Erzeugen einer Warnmeldung durch die Überlasterkennungseinheit, wenn der Parameter einen Grenzwert überschreitet.

Die vorliegende Erfindung schlägt somit eine modulare Steuervorrichtung vor, bei der auch die Einspeisemodule bzw. Peripheriemodule modular aufgebaut sind und mindestens einen Basismodulteil, einen Elektronikmodulteil und einen Anschlussmodulteil umfassen. Die nebeneinander angeordneten Basismodulteile der Einspeise- bzw. Peripheriemodule bilden das "Rückgrat" der Steuervorrichtung, mit einer Busstruktur, die die einzelnen Module untereinander und mit dem Kopfmodul der Steuervorrichtung verbindet. Vorzugsweise sind die Basismodulteile für sowohl Einspeisemodule als auch Peripheriemodule gleich ausgebildet. Die eigentliche Funktion der Module wird durch den auf das Basismodulteil aufgesteckten Elektronikmodulteil bestimmt. Das Elektronikmodulteil ist das Herzstück eines Moduls und stellt die maßgebliche Verarbeitungseinrichtung bereit, wie beispielsweise die Logik- und Schaltvorrichtung eines Peripheriemoduls. Darüber hinaus verfügen die Module über einen weiteren Anschlussmodulteil, über den eine Verbindung zur externen Peripherie hergestellt werden kann. Bei Eingangsmodulen werden über diesen Modulteil externe Meldegeräte an die Steuervorrichtung gekoppelt. Bei Ausgangsmodulen werden über das Anschlussmodulteil die zu steuernden externen Peripherieelemente mit der Steuervorrichtung verbunden und ggf. bestromt. Die externen Peripherieelemente können beispielsweise angeschlossene Aktoren wie Schütze, Magnetventile oder Lampen sein.

Bei Einspeisemodulen umfasst das Anschlussmodulteil mindestens einen Einspeiseanschluss zum Aufnehmen eines externen Peripheriestroms. Ferner führt eine elektrische Leitung mit einem definierten Querschnitt vom Einspeiseanschluss im Anschlussmodulteil durch das Elektronikmodulteil hin zum Bus im Basismodulteil. Über diese elektrische Leitung fließt vorzugsweise der gesamte eingespeiste Peripheriestrom, der für die Versorgung der an die Ausgangsmodule angeschlossenen externen Peripherie erforderlich ist. Somit fließt die Summe aller von den Ausgangsmodulen zur Verfügung gestellten Peripherieströme über die elektrische Leitung.

Weiterhin ist an die elektrische Leitung eine Überlasterkennungseinheit angeordnet, die kontinuierlich mindestens einen charakteristischen Parameter der elektrischen Leitung bestimmt. Der Parameter kann ein Wert sein, der sich direkt auf den physikalischen Zustand der elektrischen Leitung bezieht, beispielsweise dem Strom in der Leitung, oder aber einen Wert, der sich auf die Umgebung des elektrischen Leiters bezieht und Auskunft über die derzeitige Auslastung der elektrischen Leitung gibt. Ferner ist ein Grenzwert für diesen Parameter angegeben, ab dem sich die elektrische Leitung und somit auch das Einspeisemodul in einem kritischen Zustand befindet, woraufhin eine Warnmeldung von der Überlasterkennungseinheit generiert wird, die vorzugsweise unmittelbar zur Anzeige gebracht wird oder dem Kopfmodul zur Verfügung gestellt wird. Die Idee der vorliegenden Erfindung ist somit, das Einspeisemodul und insbesondere die durch den externen Peripheriestrom belasteten Komponenten kontinuierlich zu überwachen und beim Auftreten einer Überlast rechtzeitig, bevor es zum unkontrollierten Abschalten der Steuervorrichtung kommt, einzugreifen. Ein unkontrollierter störender Ausfall der Steuerungsvorrichtung kann so vermieden werden.

Die oben genannte Aufgabe ist somit vollständig gelöst.

In einer bevorzugten Ausgestaltung schaltet das Kopfmodul in Abhängigkeit der Warnmeldung den Aktor an mindestens einem Ausgang des mindestens einen Peripheriemoduls ab.

In dieser Ausgestaltung wird somit die von der Überlasterkennungseinheit erzeugte Warnmeldung über den internen Bus an das Kopfmodul weitergeleitet. Das Kopfmodul, welches dem "Gehirn" der Steuervorrichtung entspricht, kann aufgrund der Warnmeldung gezielt Peripherieelemente an den entsprechenden Ausgängen entweder abschalten oder in einen anderweitigen, stromsparenden Zustand überführen. Dadurch kann die Last eines einzelnen Einspeisemoduls reduziert werden und die Steuervorrichtung bleibt verfügbar. Darüber hinaus kann das Kopfmodul eine Warnmeldung für den Benutzer generieren, so dass dieser entsprechend reagieren kann und beispielsweise ein zusätzliches Einspeisemodul für die Steuervorrichtung bereitstellt, bevor es zu einem Ausfall kommt.

In einer weiteren Ausgestaltung weist die Überlasterkennungseinheit einen Temperatursensor, insbesondere einen NTC-Widerstand, zum Bestimmen eines Temperaturwertes der elektrischen Leitung auf.

In dieser Ausgestaltung ist der durch die Überlasterkennungseinheit zu bestimmende Parameter ein Temperaturwert der elektrischen Leitung. Bestimmt wird dieser Wert vorzugsweise durch einen NTC-Widerstand, der in der Nähe der elektrischen Leitung angeordnet ist. Der Vorteil der Temperaturmessung ist, dass neben dem für die Last charakterisierenden Wert des Stromes auch die äußeren Bedingungen mit berücksichtigt werden. So ist die Last durch den elektrischen Leiter und der Zeitpunkt, an dem es zu kritischen Ausfällen kommt, nicht nur von dem tatsächlichen Stromfluss im Leiter, sondern insbesondere auch von den äußeren Gegebenheiten abhängig. Durch die Temperaturmessung in der Nähe der elektrischen Leitung kann somit indirekt ein verlässlicher Parameter für die tatsächliche Last des elektrischen Leiters und des Einspeisemoduls bestimmt werden.

In einer besonders bevorzugten Ausgestaltung ist der Temperatursensor mit der elektrischen Leitung thermisch gekoppelt, jedoch galvanisch von der elektrischen Leitung isoliert.

Diese Ausgestaltung hat den Vorteil, dass die Last auf der elektrischen Leitung sicher über den Temperaturwert erkannt werden kann, der Temperatursensor selbst jedoch sowie die zugehörige Überlasterkennungseinheit hinsichtlich der elektromagnetischen Verträglichkeit geschützt von der Leitung angeordnet ist. Eine elektrische Überlast auf der elektrischen Leitung kann somit den Temperatursensor und die Überlasterkennungseinheit nicht beschädigen.

In einer weiteren Ausgestaltung ist die Überlasterkennungseinheit in einem Abstand zur elektrischen Leitung angeordnet, der Abstand entspricht jedoch maximal dem Dreifachen des definierten Querschnitts der elektrischen Leitung.

In dieser Ausgestaltung ist die Überlasterkennungseinheit somit nicht unmittelbar mit der elektrischen Leitung verbunden, jedoch innerhalb eines maximalen Abstandes zu dieser angeordnet, so dass eine verlässliche Aussage über die tatsächliche Last auf der elektrischen Leitung getroffen werden kann.

In einer weiteren Ausgestaltung bestimmt die Überlasterkennungseinheit mindestens einen zweiten zum ersten verschiedenartigen Parameter, der insbesondere dem Strom durch die elektrische Leitung entspricht.

Diese Ausgestaltung hat den Vorteil, dass ein weiterer Parameter vorzugsweise durch einen separaten, vom Sensor des ersten Parameters unabhängigen Sensor erfasst wird. Vorzugsweise ist dieser zweite Parameter der Strom, der durch die elektrische Leitung fließt. Dieser kann beispielsweise über einen Hall-Effektsensor oder über einen Shunt-Widerstand bestimmt werden. Während ein Hall-Effektsensor vom Prinzip her galvanisch von der elektrischen Leitung getrennt ist, ist bei einem Shunt-Widerstand zu beachten, dass dieser zusätzlich eine separate galvanische Trennung zwischen der elektrischen Leitung und der Überlasterkennungseinheit erfordert. Im Vergleich zum Hall-Effektsensor ist ein Shunt-Widerstand jedoch kostengünstiger in der Herstellung. Durch die Messung eines zweiten Parameters kann eine genauere Auswertung der Last eines Einspeisemoduls erfolgen. Insbesondere wenn der erste Parameter ein Temperaturwert ist und der zweite Parameter den Stromfluss in der elektrischen Leitung repräsentiert, kann festgestellt werden, ob ein erhöhter Temperaturwert tatsächlich auf die elektrische Last der elektrischen Leitung zurückzuführen ist oder aber, ob der Temperaturanstieg durch äußere Bedingungen hervorgerufen wird.

In einer weiteren Ausgestaltung weist die elektrische Leitung eine erste und mindestens eine zweite parallel geschaltete Leiterbahn auf.

Diese Ausgestaltung ist besonders vorteilhaft, um die Last auf der elektrischen Leitung besser zu verteilen. Da es sich bei der elektrischen Leitung vorzugsweise um eine Leiterbahn mit einer definierten Breite und Höhe handelt, ist es vorteilhaft, wenn der Strom auf eine weitere Leiterbahn, beispielsweise auf der Rückseite der Leiterplatte, verteilt werden kann. Ebenso ist es denkbar, neben der zweiten Leiterbahn noch weitere Leiterbahnen parallel zu schalten, um die Last weiter aufzuteilen. Diese weiteren Leiterbahnen können beispielsweise in den Innenlagen der Leiterplatte verlegt sein.

In einer weiteren Ausgestaltung weist das mindestens eine Peripheriemodul den ersten Ausgang und mindestens einen zweiten Ausgang auf, wobei der erste und der zweite Ausgang mit der elektrischen Leitung des Einspeisemoduls elektrisch verbunden sind.

In dieser Ausgestaltung verfügt das Ausgangsmodul nicht nur über einen Ausgang, sondern vorzugsweise über eine Vielzahl von Ausgängen, die separat, beispielsweise über Halbleiterschalter, gesteuert werden können. Durch diese Ausgestaltung kann die Steuervorrichtung vorteilhafterweise kompakter aufgebaut werden.

In einer weiteren Ausgestaltung weist das Elektronikmodulteil des Einspeisemoduls einen Stecker und das Basismodulteil des Einspeisemoduls einen entsprechenden Gegenstecker auf, die zusammengesetzt eine Steckverbindung ergeben, über die die elektrische Leitung mit der Busstruktur elektrisch gekoppelt ist, wobei die Überlasterkennungseinheit galvanisch getrennt, jedoch mit einem maximalen Abstand, der dem Dreifachen des Querschnitts der elektrischen Leitung entspricht, an der Steckverbindung angeordnet ist.

In dieser Ausgestaltung ist die Überlasterkennungseinheit, insbesondere der zur Bestimmung des Parameters relevante Sensor, an einer kritischen Stelle innerhalb des Einspeisemoduls angeordnet, an der sich eine Überlast der elektrischen Leitung besonders auswirkt. An Steckverbindungen ist, beispielsweise bei Verschleiß der Kontaktstellen durch häufiges Ein- bzw. Ausstecken, mit einem höheren Übergangswiderstand zu rechnen. Ein erhöhter Übergangswiderstand hat einen erhöhten Leitungswiderstand zur Folge, wodurch bei höherer Last an dieser Stelle mit besonders hoher Verlustleistung, beispielsweise in Form von Wärmeentwicklung, zu rechnen ist. Das Anordnen der Überlasterkennungseinheit an dieser kritischen Stelle ist daher besonders vorteilhaft, um rechtzeitig ein mögliches Versagen zu erkennen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung eines bevorzugten Ausführungsbeispiels der neuen Steuervorrichtung,
- Fig. 2: eine schematische Darstellung eines bevorzugten Ausführungsbeispiels der neuen modularen Steuervorrichtung,
- Fig. 3: eine perspektivische Innenansicht einer neuen Steuervorrichtung mit Einspeise- und Peripheriemodulen,
- Fig. 4: eine vereinfachte schematische Darstellung eines Ausführungsbeispiels einer Überlasterkennungseinheit,
- Fig. 5a: einen Querschnitt durch ein Ausführungsbeispiel der neuen Überlasterkennungseinheit,
- Fig. 5b: einen weiteren Querschnitt durch ein Ausführungsbeispiel der Überlasterkennungseinheit,
- Fig. 5c: eine Draufsicht auf ein Ausführungsbeispiel der neuen Überlasterkennungseinheit, und
- Fig. 6: eine perspektivische Darstellung eines Ausführungsbeispiels eines Einspeisemoduls.

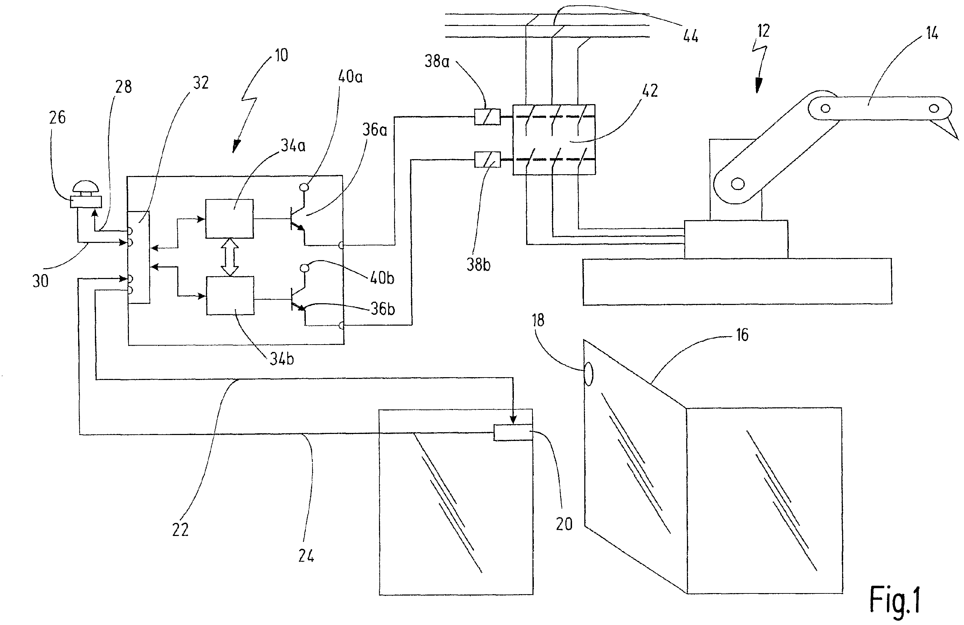

In der Fig. 1 ist ein Ausführungsbeispiel der neuen Steuervorrichtung in seiner Gesamtheit mit der Bezugsziffer 10 bezeichnet. Bei dem gezeigten Ausführungsbeispiel handelt es sich um eine Sicherheitsschaltvorrichtung, die hier zum Absichern einer technischen Anlage 12 verwendet wird. Die technische Anlage 12 ist in diesem Beispiel ein automatisiert arbeitender Roboter 14, dessen Gefahrenbere ich zum Schutz von Personen durch eine Schutztür 16 begrenzt ist. An der Schutztür befindet sich ein Türkontaktschalter mit einem Betätiger 18 und einem Sensor 20. Solange der Betätiger im Erfassungsbereich des Sensors ist, ist die Schutztür geschlossen. Wird die Schutztür geöffnet und der Betätiger 18 aus dem Erfassungsbereich des Sensors 20 herausgeführt, detektiert der Sensor diese Änderungen und signalisiert den unsicheren Zustand an die Sicherheitsschaltvorrichtung.

Im hier dargestellten Beispiel ist der Sensor 20 ein passiver Sensor, der über eine erste Leitung 22 und eine zweite Leitung 24 mit der modularen Steuervorrichtung verbunden ist. Passiv bedeutet in diesem Zusammenhang, dass der Sensor 20 nicht selbstständig ein Signal, welches den aktuellen Zustand der Schutztür repräsentiert, generiert, sondern von der modularen Steuervorrichtung 10 über die Leitung 22 mit einem Steuersignal versorgt wird. Während das Steuersignal bei geschlossener Schutztür vom Sensor unverändert über die Leitung 24 an die modulare Steuervorrichtung 10 zurückgesendet wird, wird der Signalfluss bei geöffneter Schutztür unterbrochen. Das von der Steuervorrichtung ausgesandte Signal liegt im letzteren Fall somit nicht wieder an den Eingängen der Steuervorrichtung an. Als ein weiteres Beispiel für ein Meldegerät ist in der Fig. 1 ferner ein Not-Aus-Tasters 26 dargestellt. Der Not-Aus-Taster 26 ist wie der Türkontaktschalter ein passives Meldegerät und in gleicher Weise über zwei Leitungen 28, 30 mit der modularen Steuervorrichtung verbunden. Alternative kann auch ein aktiver Sensor an die Steuervorrichtung angeschlossenen sein, wie beispielsweise eine Lichtschranke oder ein Lichtgitter, die selbsttätig ein entsprechendes Freigabesignal erzeugen. Aktive Sensoren werden auch als OSSD-Sensoren bezeichnet, wobei OSSD für " Output Signal Switching Device" steht.

Unabhängig von der Art der Sensoren, werden die Freigabesignale der Meldegeräte 16, 26 von den Eingängen 32 der modularen Steuervorrichtung aufgenommen und von der modularen Steuervorrichtung 10 verarbeitet. Im vorliegenden Ausführungsbeispiel erfolgt die Verarbeitung der Eingangssignale durch zwei redundante Mikrocontroller 34a, 34b, die unabhängig voneinander die Eingangssignale auswerten und entscheiden, ob die technische Anlage 12 abgeschaltet oder alternativ in einen sicheren Zustand überführt werden muss. Eine Abschaltung erfolgt hier über zwei Halbleiterschalter 36a, 36b, die je mit einem Schütz 38a, 38b verbunden sind.

In sicherem Zustand, d.h. wenn die Freigabesignale der Meldegeräte 20, 26 an den Eingängen 32 ordnungsgemäß anliegen, sind die Halbleiterschalter 36a, 36b durch die Mikrocontroller 34a, 34b so geschaltet, dass die Schütze 38a, 38b bestromt sind. Die Arbeitskontakte 42 der Schütze 38a, 38b liegen ferner in Serie geschaltet im Strompfad zwischen der Spannungsversorgung 44 und der technischen Anlage 12. Im bestromten Zustand der Schütze 38a, 38b zieht vorzugsweise eine Magnetspule die mechanischen Kontakte 42 in den aktiven Zustand, d.h. der Strompfad von der Spannungsversorgung 44 zur technischen Anlage 12 ist geschlossen und der Roboter betriebsbereit. Wird die Schutztür geöffnet und/oder der Not-Aus-Taster 26 betätigt, werden die Schütze von der modularen Steuervorrichtung 10 stromlos geschaltet, wobei die redundante Auslegung der Mikrocontroller 34a, 34b, Halbleiterschalter 36a, 36b und Schütze 38a, 38b dafür sorgt, dass mindestens ein Schütz 38a, 38b stromlos wird, auch wenn ein Fehler im anderen Kanal vorliegt. Da die Arbeitskontakte 42 der Schütze in Reihe geschaltet sind, ist es ausreichend, wenn nur ein Schütz abfällt, um den Roboter 14 stromloszuschalten.

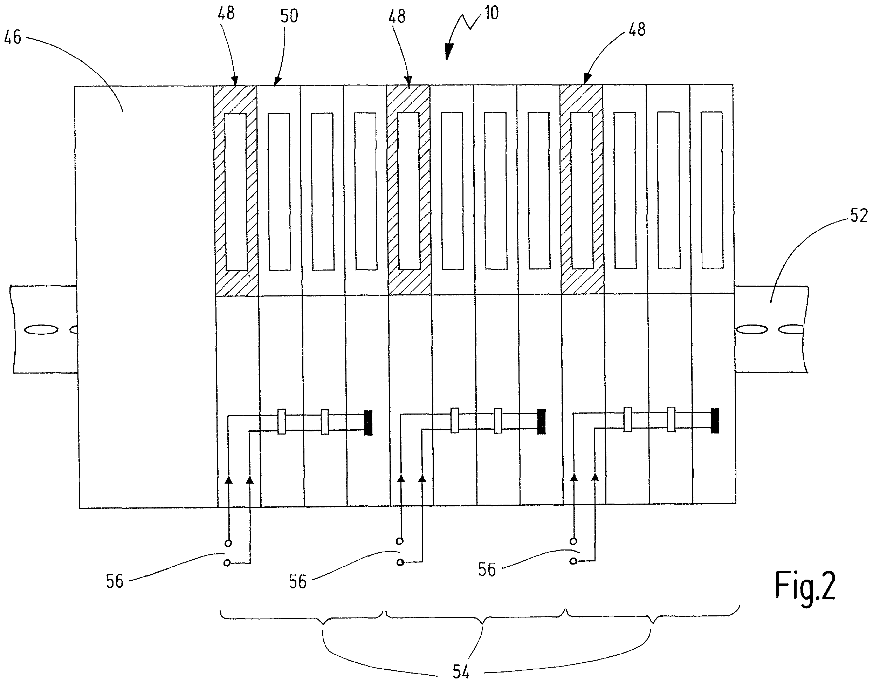

Der Strom der für die Ansteuerung der Schütze benötigt wird, wird von der Steuervorrichtung über die Ausgänge bereitgestellt und im Folgenden als Peripheriestrom bezeichnet. Die Stromversorgung ist hier durch die Anschlüsse 40a, 40b angedeutete. Wie die Steuervorrichtung den Strom bereitstellt wird im Folgenden noch näher anhand der Fig. 2 erläutert.

Fig. 2 zeigt ein Ausführungsbeispiel der neuen modularen Steuervorrichtung 10 mit einem Kopfmodul 46 und einer Vielzahl nebengeordneter Einspeise- und Peripheriemodulen 48, 50. Das Kopfmodul 46 ist vorzugsweise am Rand der modularen Steuervorrichtung 10 angeordnet und verfügt über hier nicht näher dargestellten Kommunikationsschnittstellen, um die Sensor- und Aktorebene mit übergeordneten Steuerungen zu verbinden. Eine Verbindung kann über gängige Feldbussysteme für Standardsteuerfunktionen oder aber über spezielle sichere Bussysteme wie beispielsweise der SafetyBus p für sicherheitsgerichtete Funktionen erfolgen. Ein Kopfmodul umfasst somit zumindest eine zentrale Verarbeitungseinheit und Schnittstellen zur Kommunikation.

Neben dem Kopfmodul 46 sind hier zwölf einzelne Module dargestellt, die nebeneinander in einer Reihe angeordnet sind. Es handelt sich hier um drei Einspeisemodule 48 und neun Peripheriemodule 50. Das Kopfmodul 46 sowie die weiteren Module werden vorzugsweise auf eine Hutschiene 52 aufgesteckt. Die Module sind untereinander und mit dem Kopfmodul über einen Bus verbunden, der hier nicht näher dargestellt ist. Die Module sind so ausgebildet, dass sich der Bus beim Hinzufügen neuer Module automatisch erweitert. Über den Bus werden zum einen Daten zwischen dem Kopfmodul und den einzelnen Modulen sowie zwischen den Modulen ausgetauscht und zum anderen können die einzelnen Module über dem Bus mit Strom versorgt werden. Während die Verarbeitungseinheiten der einzelnen Module vom Kopfmodul aus mit einer ausreichenden Betriebsspannung versorgt werden, müssen für Peripheriemodule, die zusätzlich externe Peripherie mit Strom versorgen, spezielle Einspeisemodule 48 vorgesehen werden, um die notwendige Spannung bereitzustellen.

Ein Einspeisemodul 48 kann mehrere Peripheriemodule 50 mit einem entsprechenden Peripheriestrom versorgen. Innerhalb der Steuervorrichtung 10 sind vorzugsweise mehrere Einspeisemodule 48 vorgesehen, um entweder verschiedene Potenzialgruppen mit unterschiedlichen Peripherieströmen zu erstellen oder um die Last auf mehrere Einspeisemodule zu verteilen. Unter einer Potenzialgruppe versteht man hier ein Einspeisemodul 48 mit den zugehörigen Peripheriemodulen 50, die von dem Einspeisemodul versorgt werden. Im Ausführungsbeispiel gemäß Fig. 2 ist die modulare Steuereinheit in drei Potenzialgruppen unterteilt. Die Zuordnung der Peripheriemodule 50 zu einem Einspeisemodul 48 erfolgt vorzugsweise durch die Reihenfolge, in der die Module nebeneinander angeordnet sind. Alternativ kann natürlich auch eine Zuordnung durch eine gezielte Verdrahtung oder anderweitige Beschaltung erfolgen.

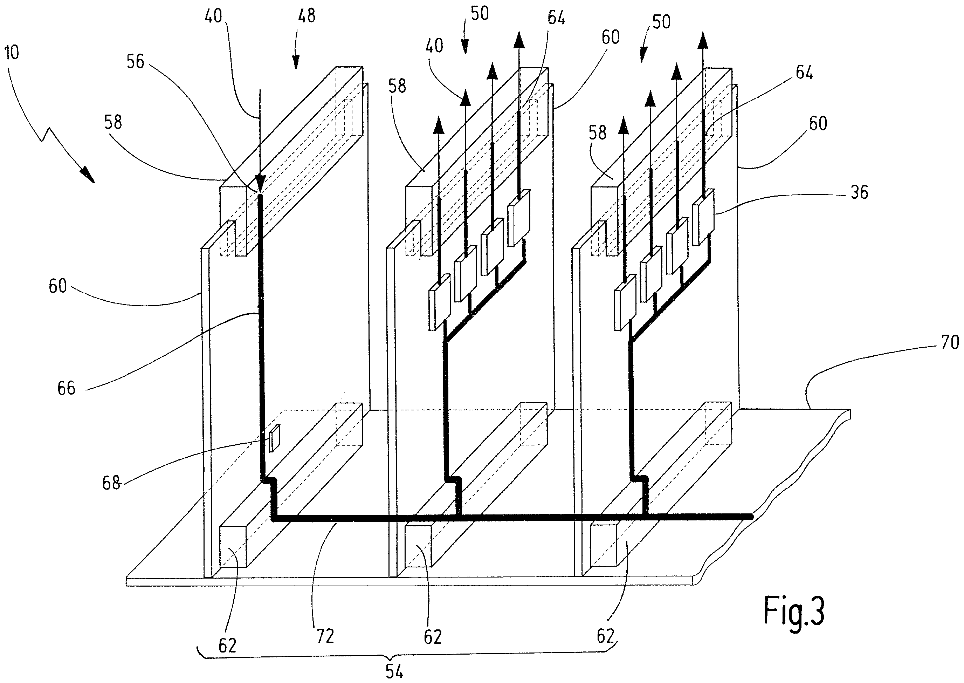

Über einen Einspeiseanschluss 56 an den Einspeisemodulen 48 wird von einem externen Netzteil der Peripheriestrom zugeführt. Der Strom wird hier über den Bus von einem Modul zum daneben liegenden Modul übertragen, bis in der Reihe ein neues Einspeisemodul 48 auftritt. Die Peripheriemodule 50 greifen über den Bus den Peripheriestrom ab und führen ihn an die angeschlossene externe Peripherie weiter, wie im Folgenden durch die Fig. 3 näher erläutert ist.

Fig. 3 zeigt in einer perspektivischen Darstellung den inneren Aufbau eines Ausführungsbeispiels der neuen Steuervorrichtung. Gleiche Bezugsziffern bezeichnen gleiche Teile.

In der Fig. 3 ist eine Potenzialgruppe 54 gezeigt. Die Potenzialgruppe 54 umfasst hier ein Einspeisemodul 48 und zwei Peripheriemodule (Ausgangsmodule) 50. Die Module 48, 50 weisen je einen Anschlussmodulteil 58, einen Elektronikmodulteil 60 und einen Basismodulteil 62 auf. Das Anschlussmodulteil ist hier bei allen Modulen in Form einer Steckerleiste 58 angedeutet. Das Anschlussmodulteil 58 des Einspeisemoduls 48 weist dabei einen einzelnen Einspeiseanschluss 56 auf, über den ein Peripheriestrom in die Potentialgruppe 54 eingespeist wird. Die Anschlussmodulteile der Peripheriemodule 50 weisen ferner je vier Ausgänge 64 auf, die individuell über Halbleiterschalter 36 gesteuert werden können und über die der Peripheriestrom 40, der vom Einspeisemodul 48 aufgenommen wurde, an die externe Peripherie abgegeben werden kann.

Die Elektronikmodulteile 60 der Peripheriemodule 50 sind hier als einfache Leiterplatten dargestellt, auf denen die Verarbeitungseinheiten der Peripheriemodule 50 angeordnet sind. Zur Vereinfachung sind hier nur die Leiterbahnen zu den Ausgängen und die entsprechenden Halbleiterschalter 36 angedeutet. Über die Halbleiterschalter 36 können die Ausgänge 40 durch eine hier nicht näher dargestellte Steuereinheit geschaltet werden. Neben binären An- und Aus-Schaltern können natürlich auch andere Ausgangssteuerungen vorgesehen werden, beispielsweise ein analoges Steuern der Ausgänge 40. Die Elektronikmodulteile 60 der Peripheriemodule 50 können darüber hinaus weitere EMV-Bauteile und/oder eine Strombegrenzung beinhalten. Über eine Strombegrenzung kann beispielsweise der maximale Strom, der von den Peripheriemodulen aufgenommen werden kann, bestimmt und festgelegt werden.

Das Elektronikmodulteil 60 des Einspeisemoduls 48 weist hier zur Verdeutlichung nur eine elektrische Leitung 66 und eine Überlasterkennungseinheit 68 auf. Die elektrische Leitung 66 verläuft hier in Form einer einzelnen Leiterbahn vom Einspeiseanschluss 56 im Anschlussmodulteil zum Basismodulteil 62.

Die Basismodulteile 62 des Einspeisemoduls 48 und der Peripheriemodule 50 sind hier durch eine Steckverbindung angedeutet. Die einzelnen Steckverbindungen 62 sind auf einer Rückwand 70 angeordnet, durch die ein Bus 72 verläuft. Der Bus 72 verbindet die Basismodulteile 62 des Einspeisemoduls 48 und der Peripheriemodule 50. Über den Bus 72 wird hier der Peripheriestrom 40, der am Einspeiseanschluss 56 des Einspeisemoduls 48 aufgenommen wird, an die Peripheriemodule 50 weitergeleitet. In einer besonders bevorzugten Ausgestaltung wird die Rückwand 70 und der Bus 72 unmittelbar von den Basismodulteilen 62 gebildet. Die Basismodulteile 62 sind dazu so ausgebildet, dass sie, wenn sie nebeneinander geschaltet sind, eine Rückwand bilden und Strukturen bereitstellen, um mindestens einen Bus 72 bereitzustellen.

Die Überlasterkennungseinheit 68 ist hier auf der Leiterplatte des Elektronikmodulteils 60 des Einspeisemoduls 48 möglichst nahe der elektrischen Leitung 66 angeordnet, auf jeden Fall jedoch galvanisch von dieser getrennt. Der Abstand zwischen der Überlasterkennungseinheit 68 und der Leiterbahn 66 ist mindestens so groß, dass ein Übersprechen gemäß EMV-Vorgaben nicht stattfinden kann, gleichwohl ist der Abstand nicht größer als das Dreifache des Querschnitts der elektrischen Leitung 66, damit sich durch die Überlasterkennungseinheit 68 ein für den Zustand der elektrischen Leitung repräsentativer Parameter bestimmen lässt. Darüber hinaus ist die Überlasterkennungseinheit 68 in unmittelbare Nähe zum Basismodulteil angeordnet, insbesondere im Bereich der elektrischen Verbindung zum Bus 72. Der Übergang zum Bus markiert einen kritischen Bereich, an dem in der Regel mit einem hohen Leitungswiderstand zu rechnen ist. Der hohe Leitungswiderstand kann beispielweise durch Verschleiß von Kontakteanschlüssen entstehen. Die Überlasterkennungseinheit ist somit vorteilhaft in der Umgebung des Übergangs angeordnet.

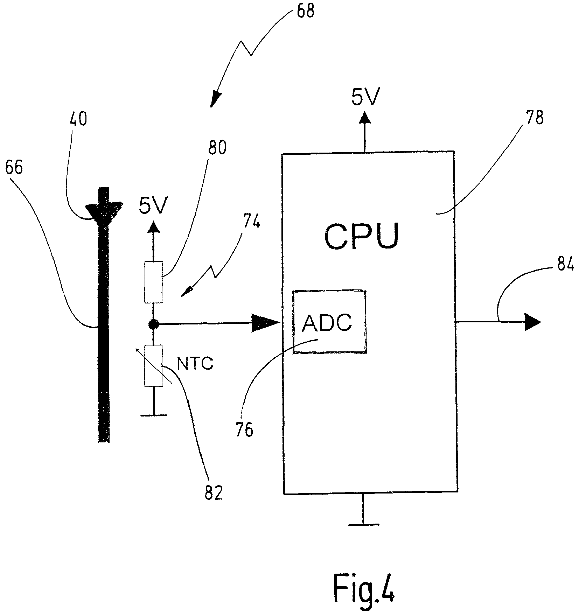

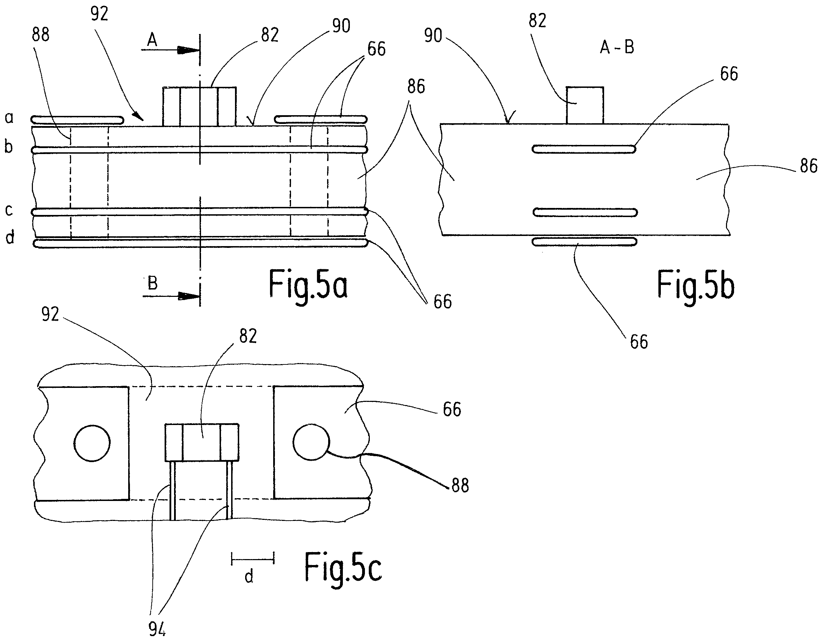

Anhand der Fig. 4, 5a, 5b und 5c wird im Folgenden näher erläutert, wie ein Ausführungsbeispiel der Überlasterkennungseinheit 68 aufgebaut ist und wie die Überlasterkennungseinheit 68 in Bezug auf die elektrische Leitung 66 angeordnet sein kann.

Im Ausführungsbeispiel gemäß Fig. 4 basiert die Überlasterkennungseinheit 68 auf einer Temperaturmessung in der unmittelbaren Umgebung der elektrischen Leitung 66. Die Temperatur der elektrischen Leitung 66 ist maßgeblich durch den Peripheriestrom 40, der durch die Leitung 66 fließt, bestimmt. Die Temperatur in unmittelbarer Nähe der elektrischen Leitung 66 beschreibt somit die elektrische Last, die durch die Leitung 66 fließt.

Die Temperatur wird in diesem Ausführungsbeispiel über einen Spannungsteiler 74, der an einen Analog-Digital-Wandler 76 eines Mikrocontrollers 78 angeschlossen ist, bestimmt. Der Spannungsteiler 74 ist aus einem konstanten Widerstand 80 und einem NTC-Widerstand 82 gebildet. Ein NTC-Widerstand 82 ist ein Heißleiter, dessen elektrischer Widerstand einen negativen Temperaturkoeffizient aufweist. Bei hohen Temperaturen leitet ein NTC-Widerstand den elektrischen Strom besser als bei tiefen Temperaturen. Über den Spannungsteiler 74 und den Analog-Digital-Wandler 76 kann von dem Mikrocontroller 78 die Temperatur der elektrischen Leitung 66 bestimmt werden.

Alternative zu einem NTC-Widerstand kann auch ein digitaler Temperatursensor verwendet werden, um die Temperatur zu bestimmen. Darüber hinaus kann die Überlasterkennungseinheit auch mehrere Sensoren umfassen, die im Falle von digitalen Sensoren beispielsweise über einen 1-wire-Bus mit dem Mikrokontroller verbunden sind. Auf diese Weise können vorteilhaft Temperaturwerte an verschiedenen Stellen innerhalb des Einspeisemoduls bestimmt werden.

Der Mikrocontroller 78 vergleicht den oder die Temperaturwerte mit einem in einem Speicher abgelegten Referenztemperaturwert und erzeugt ein Warnsignal 84, wenn der aufgenommene Temperaturwert den Referenzwert überschreitet. Das Warnsignal 84 kann unmittelbar vom Einspeisemodul 48 verarbeitet werden oder aber insbesondere an das Kopfmodul der modularen Steuervorrichtung weitergeleitet werden. Das Kopfmodul und/oder Einspeisemodul kann in Abhängigkeit des Warnsignals 84 gezielte Ausgänge abschalten oder den Stromverbrauch eines Ausgangsmoduls anderweitig senken, um die Last eines Einpeisemoduls zu senken.

Die Fig. 5a, 5b und 5c zeigen exemplarisch, wie die Überlasterkennungseinheit 68 in Form eines einzelnen Sensors an der elektrischen Leitung 66 angeordnet sein kann. Die elektrische Leitung 66 ist hier auf einer Leiterplatte 86 angeordnet und umfasst hier vier Leiterbahnen A bis D, die durch Durchkontaktierungen 88 parallel geschaltet sind. Der Peripheriestrom 40 wird somit auf vier parallel geschaltete Leiterbahnen 66 aufgeteilt und die Last auf einer einzelnen Leiterbahn verringert. Die Leiterbahnen sind vorzugsweise auf die Außen- und die Innenlagen der Leiterplatte 86 gleichmäßig verteilt.

Die Überlasterkennungseinheit 68 ist in diesem Ausführungsbeispiel durch einen NTC-Widerstand 82 angedeutet. Der NTC-Widerstand 82 ist hier ein SMD-Bauteil, das auf der Oberfläche 90 der Leiterplatte 86 angeordnet ist. Der NTC-Widerstand 82 ist galvanisch von den Leiterbahnen 86 der elektrischen Leitung getrennt. Vorzugsweise ist der NTC-Widerstand 82 jedoch so nahe an den Leiterbahnen angeordnet, wie es EMV-Bestimmungen ermöglichen.

In dem Ausführungsbeispiel gemäß Fig. 5a, 5b und 5c weist eine Leiterbahn der elektrischen Leitung 66 auf der Außenlage eine Aussparung 92 auf. Der NTC-Widerstand 82 ist vorzugsweise zentriert in der Aussparung 92 angeordnet. Die weiteren Leiterbahnen 66 verlaufen vorzugsweise zentriert unterhalb des NTC-Widerstandes 82.

Fig. 5b zeigt das Ausführungsbeispiel aus Fig. 5a im Schnitt durch die Linie A-B. Der NTC-Widerstand 82 ist mittig auf den Mittelsenkrechten der Leiterbahnen 66 auf der Oberfläche 90 der Leiterplatte 86 angeordnet. Durch die Aussparung 92 kann der Temperatursensor unmittelbar auf der Oberfläche 90 befestigt sein.

Fig. 5c zeigt das Ausführungsbeispiel der Fig. 5a und 5b in einer Draufsicht. Der NTC-Widerstand 82 ist zentriert in der Aussparung 92 der Leiterbahn 66 angeordnet. Der Abstand d zwischen NTC-Widerstand 82 und der Leiterbahn 66 ist so gewählt, dass kein Übersprechen des Peripheriestroms auf den Temperatursensor erfolgen kann. Der NTC-Widerstand 82 ist mit zwei Kontakten 94 vorzugsweise über einen Spannungsteiler an einen Analog-Digital-Konverter eines Mikrocontrollers oder einer anderen Auswerteeinheit angeschlossen, um den Widerstandswert bzw. daraus abgeleitet die Temperatur des Widerstandes zu bestimmen.

Die Überlasterkennungseinheit gemäß den Fig. 4 und 5 ist dabei nur ein mögliches Ausführungsbeispiel einer Überlasterkennungseinheit. Alternativ könnte eine Lastmessung auch durch die Bestimmung des Stroms in der elektrischen Leitung 66 erfolgen. Eine Strommessung kann beispielsweise durch ähnlich angeordnete Hall-Effekt-Sensoren erfolgen. Ein Hall-Effekt-Sensor kann dabei ähnlich galvanisch getrennt wie ein NTC-Widerstand angeordnet sein. In einem anderen Ausführungsbeispielen kann der Strom auch durch einen Shunt-Widerstand, der in Serie zu den Leiterbahnen geschaltet ist, gemessen werden. Die Messung erfolgt dabei über einen Instrumentenverstärker und einen Analog-Digital-Konverter am Mikrocontroller. Da der Shunt-Widerstand elektrisch mit der elektrischen Leitung 66 verbunden sein muss, muss zwischen der Messeinrichtung und der Auswerteeinheit eine galvanische Trennung erfolgen.

Vorteilhafterweise können die verschiedenen Arten von Sensoren kombiniert werden und an unterschiedlichen Stellen innerhalb des Einspeisemoduls angeordnet sein.

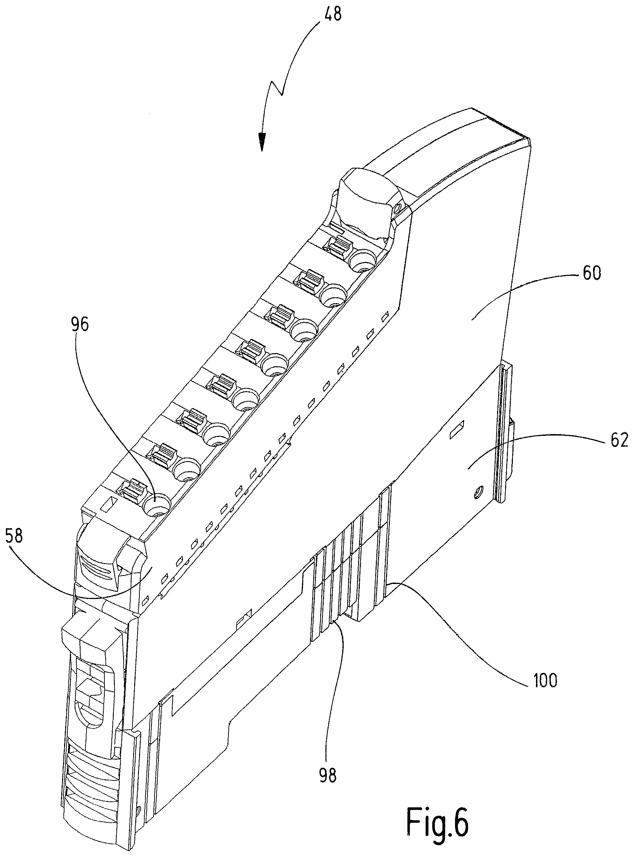

Fig. 6 zeigt ein Ausführungsbeispiel eines einzelnen Einspeisemoduls 48. Das Modul umfasst einen Anschlussmodulteil 58, einen Elektronikmodulteil 60 und ein Basismodulteil 62. Die Modulteile sind mechanisch zu einer Einheit zusammengesetzt und elektrisch miteinander verbunden. Vorzugsweise wird die Funktion des Moduls durch das Elektronikmodulteil bestimmt, während das Anschlussmodulteil und das Basismodulteil auch für andere Module verwendet werden kann.

Das Anschlussmodulteil 58 weist hier acht Anschlussklemmen für eine externe Verdrahtung auf. Eine Anschlussklemme 96 könnte beispielsweise als Einspeiseanschluss dienen. In besonders bevorzugten Ausführungsbeispielen ist das Anschlussmodulteil 58 Teil eines vorkonfektionierten Kabelbaums. Auf diese Weise lassen sich die Module einfach und fehlerfrei verkabeln.

Im Elektronikmodulteil 60 sind die Verarbeitungseinheiten des Moduls angeordnet. Neben der erfindungsgemäßen Überlasterkennungseinheit 82 können in dem Elektronikmodul eines Einspeisemoduls u.a. auch Schaltungsteile zur Verarbeitung des Peripheriestroms, wie beispielsweise ein Strombegrenzer und/oder Stromglätter angeordnet sein.

Das Elektronikmodulteil 60 wird auf einen Basismodulteil 62 aufgesteckt, wobei das Basismodulteil 62 Schnittstellen zu nebengeordneten Modulen bzw. zum Kopfmodul bereitstellt. Die Verbindung erfolgt über einen Bus, dessen Struktur durch die einzelnen Basismodulteile 62 der Module der Steuervorrichtung gebildet wird. Hierzu weist das Basismodulteil 62 seitlich Kontakte 98, 100 auf, die die nebengeordnete Basismodulteile kontaktieren und darüber einen Bus durchschleifen. Im Ausführungsbeispiel gemäß Fig. 6 sind zwei Busstrukturen angedeutet. Der erste Bus, hier durch die Kontakte 98 angedeutet, bildet einen Datenbus, über den Informationen von einem Modul zum anderen und/oder zum Kopfmodul übertragen werden können. Der mit den Kontakten 100 angedeutete Bus ist hier ein Versorgungsspannungsbus, über den der Peripheriestrom übertragen wird. Im gezeigten Ausführungsbeispiel wird somit ein Peripheriestrom über einen Einspeiseanschluss, der hier aus den Anschlussklemmen 96 gebildet ist, aufgenommen, im Elektronikmodulteil 60 verarbeitet und durch eine erfindungsgemäße Überlasterkennungseinheit überwacht und anschließend über die Kontakte 100 im Basismodulteil 62 an nebengeordnete Module weitergegeben. Wird von der Überlasterkennungseinheit eine Überlastsituation, die durch einen zu hohen Strom auf der elektrischen Leitung zwischen dem Einspeiseanschluss und den Kontakten am Basismodulteil hervorgerufen ist oder auf eine Überhitzung des Moduls zurückzuführen ist, kann die Überlasterkennungseinheit eine Warnmeldung ausgeben, die über den Datenbus an den Kontakten 98 an die nebengeordneten Module oder aber insbesondere ans Kopfmodul weitergeleitet wird. Das Kopfmodul und/oder die zugehörigen Peripheriemodule können daraufhin die Last für das Einspeisemodul begrenzen, indem sie Ausgänge der Peripheriemodule ansteuern, insbesondere abschalten, um die Last im Einspeisemodul zu verringern.

## Patentansprüche

1. Modulare Steuervorrichtung (10) mit einem Kopfmodul (46), mindestens einem Einspeisemodul (48) und mindestens einem Peripheriemodul (50), die nebeneinander am Kopfmodul (46) angeordnet sind, und mit mindestens einer Busstruktur (72), wobei das mindestens eine Einspeisemodul (48) und das mindestens eine Peripheriemodul (50) einen Basismodulteil (62), einen Elektronikmodulteil (60) und einen Anschlussmodulteile (58) aufweisen,
**gekennzeichnet dadurch, dass** das mindestens eine Einspeisemodul (48) dazu ausgebildet ist, das mindestens eine Peripheriemodul (50) mit einem externen Peripheriestrom (40) zu versorgen,
wobei das Anschlussmodulteil (58) des mindestens einen Einspeisemoduls (48) einen Einspeiseanschluss (56) zum Einspeisen des externen Peripheriestroms (40) aufweist,
wobei das Anschlussmodulteil (58) des mindestens einen Peripheriemoduls (50) einen Ausgang (64) zum Anschließen eines Aktors (38) bereitstellt zum Ausgeben des in das Einspeisemodul (56) eingespeisten Peripheriestroms (40),
wobei die nebeneinander angeordneten Basismodulteile (62) die Busstruktur (72) bereitstellen, über die das Kopfmodul (46), das mindestens eine Einspeisemodul (48) und das mindestens eine Peripheriemodul (50) miteinander elektrisch gekoppelt sind, so dass der externe Peripheriestrom (40) über die Busstruktur (72) von einem Modul zum danebenliegenden Modul übertragen werden kann,
wobei das Einspeisemodul (48) ferner aufweist:
eine elektrische Leitung (66) mit einem definierten Querschnitt, die vom Anschlussmodulteil (58) durch das Elektronikmodulteil (60) hin zum Basismodulteil (62) verläuft und den mindestens einen Einspeiseanschluss (56) des Einspeisemoduls (48) mit der Busstruktur (72) verbindet,
und eine Überlasterkennungseinheit (68), die an der elektrischen Leitung (66) angeordnet ist und einen Parameter der elektrischen Leitung (66) bestimmt und eine Warnmeldung erzeugt, wenn der Parameter einen Grenzwert überschreitet.

2. Modulare Steuervorrichtung nach Anspruch 1, wobei das Kopfmodul (46) in Abhängigkeit der Warnmeldung den Aktor (38) an mindestens einem Ausgang (64) des mindestens einen Peripheriemoduls (50) abschaltet.

3. Modulare Steuervorrichtung nach einem der Ansprüche 1 oder 2, wobei die Überlasterkennungseinheit (68) einen Temperatursensor, insbesondere einen NTC-Widerstand (82), zum Bestimmen eines Temperaturwerts der elektrischen Leitung (66) aufweist.

4. Modulare Steuervorrichtung nach Anspruch 3, wobei der Temperatursensor mit der elektrischen Leitung (66) thermisch gekoppelt ist, jedoch galvanisch von der elektrischen Leitung (66) isoliert ist.

5. Modulare Steuervorrichtung nach einem der Ansprüche 1 bis 4, wobei die Überlasterkennungseinheit (68) in einem Abstand zur elektrischen Leitung angeordnet ist, der Abstand jedoch maximal dem 3-fachen des definierten Querschnitts der elektrischen Leitung (66) entspricht.

6. Modulare Steuervorrichtung nach einem der Ansprüche 1 bis 5, wobei die Überlasterkennungseinheit (68) mindestens einen zweiten zum ersten verschiedenartigen Parameter bestimmt, der insbesondere dem Strom durch die elektrische Leitung (66) entspricht.

7. Modulare Steuervorrichtung nach einem der Ansprüche 1 bis 6, wobei die elektrische Leitung (66) eine erste und mindestens eine zweite parallelgeschaltete Leiterbahn aufweist und sich der Peripheriestrom (40) auf die erste und mindestens zweite Leiterbahn verteilt.

8. Modulare Steuervorrichtung nach einem der Ansprüche 1 bis 7, wobei das mindestens eine Peripheriemodul (50) den ersten Ausgang und mindestens einen zweiten Ausgang aufweist, wobei der erste und der zweite Ausgang mit der elektrischen Leitung (66) des Einspeisemoduls (48) elektrisch verbunden sind.

9. Modulare Steuervorrichtung nach einem der Ansprüche 1 bis 8, ferner aufweisend mindestens ein weiteres Peripheriemodul (51), wobei der Peripheriestrom vom Einspeisemodul (48) in das erste und das weitere Peripheriemodul (50, 51) eingespeist wird.

10. Modulare Steuervorrichtung nach einem der Ansprüche 1 bis 9, wobei das Elektronikmodulteil (60) des Einspeisemoduls (48) einen Stecker und das Basismodulteil des Einspeisemoduls einen entsprechenden Gegenstecker aufweist, die zusammengesetzt eine Steckverbindung ergeben, über die die elektrische Leitung (66) mit der Busstruktur (72) elektrisch gekoppelt ist, wobei die Überlasterkennungseinheit (68) galvanisch getrennt, jedoch mit einem maximalen Abstand, der das 3-fache des Querschnitts der elektrischen Leitung entspricht, an der Steckverbindung angeordnet ist.

11. Einspeisemodul (48) für eine modulare Steuervorrichtung, die ein Kopfmodul (46) und mindestens ein Peripheriemodul (50) aufweist, die über eine Busstruktur (72) miteinander gekoppelt sind, wobei das Einspeisemodul (48) einen Basismodulteil (62), einen Elektronikmodulteil (60) und einen Anschlussmodulteil (58) mit mindestens einem Einspeiseanschluss (56) aufweist **gekennzeichnet dadurch, dass** das mindestens eine Einspeisemodul (48) dazu ausgebildet ist, mindestens ein Peripheriemodul (50) mit einem externen Peripheriestrom (40) zu versorgen, wobei das Einspeisemodul (48) eine elektrische Leitung (66) mit einem definierten Querschnitt aufweist, die vom Anschlussmodulteil (58) durch das Elektronikmodulteil (60) hin zum Basismodulteil (62) verläuft, so dass der mindestens eine Einspeiseanschluss (56) des Einspeisemoduls (48) mit der Busstruktur (72) verbindbar ist, und wobei das Einspeisemodul (48) eine Überlasterkennungseinheit (68) aufweist, die an der elektrischen Leitung (66) angeordnet ist und einen Parameter der elektrischen Leitung (66) bestimmt und eine Warnmeldung erzeugt, wenn der Parameter einen Grenzwert überschreitet.

12. Verfahren zum Einspeisen eines Peripheriestroms (40) in eine modulare Steuervorrichtung mit den Schritten:
- Bereitstellen einer modularen Steuervorrichtung (10) mit einem Kopfmodul (46), mindestens einem Einspeisemodul (48) und mindestens einem Peripheriemodul (50), die nebeneinander am Kopfmodul (46) angeordnet sind, wobei das mindestens eine Einspeisemodul (48) und das mindestens eine Peripheriemodul (50) mindestens einen Basismodulteil (62), einen Elektronikmodulteil (60) und einen Anschlussmodulteil (58) aufweisen,
**gekennzeichnet durch**
- Aufnehmen eines externen Peripheriestroms (40) über einen Einspeiseanschluss (56) am Anschlussmodulteil (58) des mindestens einen Einspeisemoduls (48),
- Bereitstellen einer Busstruktur (72) aus den nebeneinander angeordneten Basismodulteilen (62), über die das Kopfmodul (46), das mindestens eine Einspeisemodul (48) und das mindestens eine Peripheriemodul (50) miteinander elektrisch gekoppelt sind, so dass der Peripheriestrom über die Busstruktur von einem Modul zum danebenliegenden Modul übertragen werden kann,
- Versorgen des mindestens eine Peripheriemodul (50) mit dem Peripheriestrom (40) durch das mindestens eine Einspeisemodul (48),
- Bereitstellen einer elektrischen Leitung (66) in dem mindestens einen Einspeisemodul (48) mit einer Überlasterkennungseinheit (68), wobei die elektrische Leitung (66) einen definierten Querschnitt aufweist und vom Anschlussmodulteil (58) durch das Elektronikmodulteil (60) hin zum Basismodulteil (62) verläuft und den mindestens einen Einspeiseanschluss (56) des Einspeisemoduls (48) mit der Busstruktur (72) verbindet,
- Ausgeben des Peripheriestroms (40) über einen Ausgang (64) am Anschlussmodulteil (58) des mindestens einen Peripheriemoduls (50),
- Bestimmen eines Parameters der elektrischen Leitung (66) durch die Überlasterkennungseinheit (68), und
- Erzeugen einer Warnmeldung durch die Überlasterkennungseinheit (68), wenn der Parameter einen Grenzwert überschreitet.

## Claims

1. Modular control device (10) having a head module (46), at least one supply module (48) and at least one peripheral module (50), which are arranged next to one another on the head module (46), and having at least one bus structure (72),
wherein the at least one supply module (48) and the at least one peripheral module (50) have a base module part (62), an electronic module part (60) and a terminal module part (58),
**characterized in that** said at least one supply module (48) is adapted to supply said at least one peripheral module (50) with an external peripheral current (40),
wherein the terminal module part (58) of the at least one supply module (48) has a supply terminal (56) for receiving the external peripheral current (40),
wherein the terminal module part (58) of the at least one peripheral module (50) provides an output (64) for connecting an actuator (38) for outputting the peripheral current (40) received by the supply terminal (56),
wherein the base module parts (62) arranged next to one another provide the bus structure (72) via which the head module (46), the at least one supply module (48) and the at least one peripheral module (50) are electrically coupled to one another, so that the external peripheral current (40) can be transmitted via the bus structure (72) from one module to the adjacent module,
wherein said supply module (48) further comprises:
an electrical line (66) with a defined cross-section, which runs from the terminal module part (58) through the electronic module part (60) to the base module part (62) and connects the at least one supply terminal (56) of the supply module (48) to the bus structure (72),
and an overload detection unit (68) which is arranged on said electrical line (66), determines a parameter of said electrical line (66), and generates a warning message when said parameter exceeds a threshold.

2. The modular control device according to claim 1, wherein the head module (46) switches off the actuator (38) at at least one output (64) of the at least one peripheral module (50) as a function of the warning message.

3. The modular control device according to any one of claims 1 or 2, wherein the overload detection unit (68) comprises a temperature sensor, in particular an NTC resistor (82), for determining a temperature value of the electrical line (66).

4. The modular control device according to claim 3, wherein the temperature sensor is thermally coupled to the electrical line (66) but galvanically isolated from the electrical line (66).

5. The modular control device according to any one of claims 1 to 4, wherein the overload detection unit (68) is arranged at a distance from the electrical line, but the distance corresponds at most to 3 times the defined cross-section of the electrical line (66).

6. The modular control device according to any one of claims 1 to 5, wherein the overload detection unit (68) determines at least one second parameter which is different from the first parameter and which corresponds in particular to the current through the electrical line (66).

7. The modular control device according to any one of the claims 1 to 6, wherein the electrical line (66) has a first and at least one second conductor track connected in parallel and the peripheral current (40) is distributed over the first and at least second conductor track.

8. The modular control device according to any of claims 1 to 7, wherein the at least one peripheral module (50) comprises the first output and at least one second output, the first and second output being electrically connected to the electrical line (66) of the supply module (48).

9. The modular control device according to any of claims 1 to 8, further comprising at least one further peripheral module (51), wherein the peripheral current is fed from the supply module (48) into the first and further peripheral module (50, 51).

10. The modular control device according to any one of claims 1 to 9, wherein the electronic module part (60) of the supply module (48) has a plug and the base module part of the supply module has a corresponding mating plug, which together form a plug connection via which the electrical line (66) is electrically coupled to the bus structure (72), wherein the overload detection unit (68) is arranged electrically isolated at the plug connection at a maximum distance corresponding to 3 times the cross-section of the electrical line.

11. Supply module (48) for a modular control device which has a head module (46) and at least one peripheral module (50) which are coupled to one another via a bus structure (72), the supply module (48) having a base module part (62), an electronic module part (60) and a terminal module part (58) with at least one supply terminal (56), **characterized in that** the at least one supply module (48) is configured to supply at least one peripheral module (50) with an external peripheral current (40), wherein the supply module (48) has an electrical line (66) with a defined cross-section which runs from the terminal module part (58) through the electronic module part (60) to the base module part (62), so that the at least one supply terminal (56) of the supply module (48) can be connected to the bus structure (72), and wherein the supply module (48) comprises an overload detection unit (68) which is arranged on the electrical line (66), determines a parameter of the electrical line (66), and generates a warning message when the parameter exceeds a threshold.

12. A method of feeding a peripheral current (40) into a modular control device comprising the steps of:
- Providing a modular control device (10) having a head module (46), at least one supply module (48) and at least one peripheral module (50) arranged side by side on the head module (46), wherein the at least one supply module (48) and the at least one peripheral module (50) comprise at least a base module part (62), an electronic module part (60), and a terminal module part (58);
**characterized by**
- Receiving an external peripheral current (40) via a supply terminal (56) on the terminal module part (58) of the at least one supply module (48);
- Providing a bus structure (72) from the base module parts (62) arranged next to one another, via which the head module (46), the at least one supply module (48) and the at least one peripheral module (50) are electrically coupled to one another, so that the peripheral current can be transmitted via the bus structure from one module to the adjacent module;
- Supplying the at least one peripheral module (50) with the peripheral current (40) by the at least one supply module (48);
- Providing an electrical line (66) in the at least one supply module (48) with an overload detection unit (68), wherein the electrical line (66) has a defined cross-section and extends from the terminal module part (58) through the electronic module part (60) to the base module part (62) and connects the at least one supply terminal (56) of the supply module (48) to the bus structure (72);
- Outputting the peripheral current (40) via an output (64) on the terminal module part (58) of the at least one peripheral module (50);
- Determining a parameter of the electrical line (66) by the overload detection unit (68); and
- Generating a warning message by the overload detection unit (68) when the parameter exceeds a threshold.

## Revendications

1. Dispositif de commande modulaire (10) comprenant un module de tête (46), au moins un module d'alimentation (48) et au moins un module périphérique (50), lesquels sont disposés côte à côte au niveau du module de tête (46), et au moins une structure de bus (72), l'au moins un module d'alimentation (48) et l'au moins un module périphérique (50) comportant une partie de module de base (62), une partie de module électronique (60) et une partie de module de connexion (58),
**caractérisé en ce que** l'au moins un module d'alimentation (48) est conçu pour alimenter l'au moins un module périphérique (50) avec un courant périphérique externe (40),
la partie de module de connexion (58) de l'au moins un module d'alimentation (48) comportant une connexion d'alimentation (56) destinée à injecter le courant périphérique externe (40),
la partie de module de connexion (58) de l'au moins un module périphérique (50) produisant une sortie (64) destinée à être connectée à un actionneur (38) pour délivrer le courant périphérique (40) injecté dans le module d'alimentation (56),
les parties de module de base (62) disposées côte à côte produisant la structure de bus (72) qui permet de coupler électriquement le module de tête (46), l'au moins un module d'alimentation (48) et l'au moins un module périphérique (50) entre eux de sorte que le courant périphérique externe (40) puisse être transmis d'un module au module adjacent via la structure de bus (72),
le module d'alimentation (48) comprenant en outre :
une ligne électrique (66) de section transversale définie qui s'étend de la partie de module de connexion (58) à la partie de module de base (62) en passant par la partie de module électronique (60) et reliant au moins une borne d'alimentation (56) du module d'alimentation (48) à la structure de bus (72),
et une unité de détection de surcharge (68) disposée sur la ligne électrique (66) et déterminant un paramètre de la ligne électrique (66) et générant un message d'avertissement lorsque le paramètre devient supérieur à un seuil.

2. Dispositif de commande modulaire selon la revendication 1, le module de tête (46) désactivant l'actionneur (38) au niveau d'au moins une sortie (64) de l'au moins un module périphérique (50) en fonction du message d'avertissement.

3. Dispositif de commande modulaire selon l'une des revendications 1 et 2, l'unité de détection de surcharge (68) comprenant un capteur de température, en particulier une résistance NTC (82), destiné à déterminer une valeur de température de la ligne électrique (66).

4. Dispositif de commande modulaire selon la revendication 3, le capteur de température étant couplé thermiquement à la ligne électrique (66) mais isolé galvaniquement de la ligne électrique (66).

5. Dispositif de commande modulaire selon l'une des revendications 1 à 4, l'unité de détection de surcharge (68) étant disposée à une distance de la ligne électrique, la distance correspondant cependant au maximum à 3 fois la section transversale définie de la ligne électrique (66).

6. Dispositif de commande modulaire selon l'une des revendications 1 à 5, l'unité de détection de surcharge (68) déterminant au moins un deuxième paramètre, différent du premier, qui correspond en particulier au courant circulant à travers la ligne électrique (66).

7. Dispositif de commande modulaire selon l'une des revendications 1 à 6, la ligne électrique (66) comportant une première piste conductrice et au moins une deuxième piste conductrice qui sont montées en parallèle et le courant périphérique (40) se répartissant entre la première piste conductrice et l'au moins une deuxième piste conductrice.

8. Dispositif de commande modulaire selon l'une des revendications 1 à 7, l'au moins un module périphérique (50) comportant la première sortie et au moins une deuxième sortie, les première et deuxième sorties étant reliées électriquement à la ligne électrique (66) du module d'alimentation (48).

9. Dispositif de commande modulaire selon l'une des revendications 1 à 8, comprenant en outre au moins un autre module périphérique (51), le courant périphérique provenant du module d'alimentation (48) étant injecté dans le premier et l'autre module périphérique (50, 51).

10. Dispositif de commande modulaire selon l'une des revendications 1 à 9, la partie de module électronique (60) du module d'alimentation (48) comportant un connecteur et la partie de module de base du module d'alimentation comportant un connecteur homologue correspondant qui établissent, une fois assemblés, une connexion par enfichage qui couple la ligne électrique (66) électriquement à la structure de bus (72), l'unité de détection de surcharge (68) étant séparée galvaniquement, mais disposée au niveau de la connexion par enfichage à une distance maximale qui correspond à 3 fois la section transversale de la ligne électrique.

11. Module d'alimentation (48) destiné à un dispositif de commande modulaire qui comporte un module de tête (46) et au moins un module périphérique (50) qui sont couplés l'un à l'autre par le biais d'une structure de bus (72), le module d'alimentation (48) comportant une partie de module de base (62), une partie de module électronique (60) et une partie de module de connexion (58) pourvue d'au moins une connexion d'alimentation (56), **caractérisé en ce que** l'au moins un module d'alimentation (48) est conçu pour alimenter au moins un module périphérique (50) avec un courant périphérique externe (40), le module d'alimentation (48) comportant une ligne électrique (66) de section transversale définie qui s'étend de la partie de module de connexion (58) à la partie de module de base (62) en passant par la partie de module électronique (60) de sorte que l'au moins une borne d'alimentation (56) du module d'alimentation (48) peut être reliée à la structure de bus (72), et le module d'alimentation (48) comportant une unité de détection de surcharge (68) qui est disposée au niveau de la ligne électrique (66) et qui détermine un paramètre de la ligne électrique (66) et qui génère un message d'avertissement lorsque le paramètre devient supérieur à un seuil.

12. Procédé d'injection d'un courant périphérique (40) dans un dispositif de commande modulaire, le procédé comprenant les étapes suivantes :
- fournir un dispositif de commande modulaire (10) pourvu d'un module de tête (46), d'au moins un module d'alimentation (48) et d'au moins un module périphérique (50) qui sont disposés côte à côte au niveau du module de tête (46), l'au moins un module d'alimentation (48) et l'au moins un module périphérique (50) comportant au moins une partie de module de base (62), une partie de module électronique (60) et une partie de module de connexion (58),
**caractérisé par** les étapes suivantes
- recevoir un courant périphérique externe (40) par le biais d'une borne d'alimentation (56) située au niveau de la partie de module de connexion (58) de l'au moins un module d'alimentation (48),
- fournir une structure de bus (72) à partir des parties de module de base (62) qui sont disposées côté à côté et qui permettent de coupler électriquement le module de tête (46), l'au moins un module d'alimentation (48) et l'au moins un module périphérique (50) entre eux de sorte que le courant périphérique puisse être transmis d'un module au module adjacent par le biais de la structure de bus,
- alimenter l'au moins un module périphérique (50) avec le courant périphérique (40) par le biais de l'au moins un module d'alimentation (48),
- munir une ligne électrique (66), dans l'au moins un module d'alimentation (48), d'une unité de détection de surcharge (68), la ligne électrique (66) ayant une section transversale définie et s'étendant de la partie de module de connexion (58) à la partie de module de base (62) en passant par la partie de module électronique (60) et reliant l'au moins une borne d'alimentation (56) du module d'alimentation (48) à la structure de bus (72),
- délivrer le courant périphérique (40) par le biais d'une sortie (64) au niveau de la partie de module de connexion (58) de l'au moins un module périphérique (50),
- déterminer un paramètre de la ligne électrique (66) au moyen de l'unité de détection de surcharge (68), et
- générer un message d'avertissement au moyen de l'unité de détection de surcharge (68) lorsque le paramètre devient supérieur à un seuil.
